# EUROPEAN PATENT SPECIFICATION

(11) **EP 0 472 776 B1**
(45) Date of publication and mention of the grant of the patent: **28.06.1995**
(21) Application number: 90120371.1
(22) Date of filing: 24.10.1990
(51) Int. Cl.: C04B 35/58

(54) **Aluminum nitride powder, sintered body and production thereof**
Aluminiumnitridpulver, Sinterkörper und Verfahren zu seiner Herstellung
Poudre de nitrure d'aluminium, corps fritté et son procédé de fabrication

(30) Priority: 06.08.1990 JP 206768/90
(43) Date of publication of application: 04.03.1992
(73) Proprietor: SUMITOMO ELECTRIC INDUSTRIES, LTD., Osaka-shi, Osaka 541 (JP)
(72) Inventor: Yamakawa, Akira, c/o Itami Works of, Itami-shi, Hyogo (JP); Shimoda, Kouhei, c/o Itami Works of, Itami-shi, Hyogo (JP); Miyake, Masaya, c/o Itami Works of, Itami-shi, Hyogo (JP); Sogabe, Koichi, c/o Itami Works of, Itami-shi, Hyogo (JP)
(74) Representative: Kahler, Kurt, Dipl.-Ing.

(56) References cited:
- EP-A- 0 114 193
- EP-A- 0 321 975
- EP-A- 0 342 595
- EP-A- 0 371 315
- US-A- 4 877 760
- IEEE PROCEEDINGS OF THE ELECTRONIC COMPONENTS CONFERENCE 1989, New York, US; C. JIDUO et al.: "Research on Manufacturing Aluminium Nitride Powder by Reduction"
- CHEMICAL ABSTRACTS vol. 110, no. 8, 17 April 1989, page 324, abstract no. 140353g, Columbus, Ohio, US
- CHEMICAL ABSTRACTS vol. 109, no. 4, 25 July 1988, page 238, abstract No. 26704b, Columbus, Ohio, US
- CHEMICAL ABSTRACTS vol. 109, no. 8, August 1988, page 347, abstract no. 60166n, Columbus, Ohio, US
- CHEMICAL ABSTRACTS vol. 110, no. 29, May 1989, page 331, abstract no. 198032t, Columbus, Ohio, US
- CHEMICAL ABSTRACTS vol. 109, no. 22 November 1988, page 369, abstract no. 195983x, Columbus, Ohio, US
- CHEMICAL ABSTRACTS vol. 109, no. 20, 29 November 1988, page 308, abstract no. 175293u, Columbus, Ohio, US

## Description

### BACKGROUND OF THE INVENTION

### 1. Field of the Invention

The present invention relates to colored sintered bodies of aluminum nitride and, more specifically, to sintered bodies of aluminum nitride which have a high degree of density, thermal conductivity and flexural strength together with a desired color, such as black, brown, green, etc.

The present invention further relates to aluminum nitride powder useful for the preparation of the sintered bodies and to substrates for circuit boards and packages for semiconductor devices using the sintered bodies.

### 2. Description of the Prior Art

In recent years, there has been a remarkable progress in large scale integration (LSI) technology and considerable improvements have been made in the integration techniques. Improvements in size of integrated circuit (IC) chips contribute to such recent LSI innovations and, with such improvements in the size of IC chips, generation of heat for each package is increased. Accordingly, the heat dissipation property of substrate materials has become increasingly important. Heretofore, sintered alumina has been employed as an IC substrate material. However, since the thermal conductivity of the sintered alumina is not sufficient for permitting satisfactory heat release, the conventional sintered alumina can not be adapted to such increasing heat generation of IC chips. For this, a beryllia substrate having a high thermal conductivity has been studied as a substitute for the sintered alumina substrate, but it is difficult to handle because of its strong toxity.

On the other hand, sintered aluminum nitride (AlN) is recently attracting attention as substrate materials for circuit boards and packaging materials in the semiconductive industry, because it inherently has a high thermal conductivity and a high electrical insulating property and is nontoxic.

As set forth above, monocrystalline aluminum nitride is theoretically a material having a high thermal conductivity and a good insulating property. However, in case where sintered bodies are prepared from aluminum nitride powder by molding followed by sintering, the resultant sintered bodies, although depending on sintering conditions, exhibit a low relative density, i.e., at most, of the order of 70 to 80% (with reference to the theoretical density of 3.26 g/cm³ of aluminum nitride) because of poor sinterability of aluminum nitride powder per se, and include a large number of pores.

The mechanism of heat conduction in insulating ceramics, like aluminum nitride sintered body, is made mainly through phonon conduction. Thus, phonon scattering is caused due to defects such as pores, impurities, etc., of the ceramics and, thereby, the heat conduction level is reduced. Under such circumstances, various proposals have been made to achieve aluminum nitride sintered products having a high thermal conductivity.

JP-A-63-156007 (CHEMICAL ABSTRACTS, Vol. 109, no. 20, November 29, 1988, page 308) discloses an aluminum nitride powder produced by fusing, atomizing and nitriding a mixture of Al-metal powder and 0.3 - 10 parts of Ba, Ca, Ce, Co, La, Nb and/or Y. The so manufactured AlN powder can be sintered to obtain an AlN body with a thermal conductivity of 130 W/m.K.

EP-A-0 342 595 discloses a colored sintered body of aluminum nitride comprising AlN as a main component and at least one component selected from the group consisting of Zr, Hf, V, Nb, Ta, Cr, Mo, W, Fe, Co, Ni, Nd and Ho. The sintered body being useful for the preparation of circuit boards and ceramic packages has a thermal conductivity of at least 150 W/m.K. The above-mentioned metals are added as separate additives to the AlN powder.

However, in order to produce aluminum nitride sintered products of high thermal conductivity, highly pure raw materials should be employed and inclusion of impurities which may be caused during the production process should be held as small as possible. Sintered products of aluminum nitride obtained in such conditions are limited to white transparent products or faintly colored products and can not be used for applications where light-transmitting property is very important. Accordingly, it is highly desirable to develop colored sintered bodies of aluminum nitride for such applications.

### SUMMARY OF THE INVENTION

Under the above circumstances, an object of the present invention is to provide a colored sintered body of aluminum nitride having a high thermal conductivity and a high flexural strength.

Another object of the present invention is to provide a material powder used for preparing such a sintered body.

A further object of the present invention is to provide a substrate material for a circuit board and a packaging material for a semiconductor device in which the sintered body is employed.

The present inventors have been made many studies and extensive experimentation to eliminate the above-mentioned disadvantages and arrived at the discovery that aluminum nitride powder containing certain elements and/or their compounds is effective. The present invention has been made based on this discovery.

According to the present invention, there is provided an aluminum nitride powder comprising (i) aluminium nitride as a main component and (ii) at least one metal element selected from the group consisting of Ti, Zr; Hf, V, Ta, Cr, Mo, W, Mn, Ni, Nd and Ho and/or one or more compounds thereof incorporated and dispersed in each crystal grain as a coloring agent in the total amount of 0.1 to 3.0% by weight as metal based on the weight of AlN. Throughout the specification, the amounts of metal elements and/or their compounds contained in the aluminum nitride powder or added to the powder are all indicated based on the weight of AlN, unless otherwise specified.

Such a material powder is prepared by mixing Al₂O₃ powder and carbon powder at a weight ratio of 1 : 0.2 to 1 : 2 and firing the resulting mixture in the presence of at least one metal element selected from the group consisting of Ti, Zr, Hf; V, Ta, Cr, Mo, W, Mn, Ni, Nd and Ho and/or one or more compounds thereof to be incorporated and dispersed in each crystal grain as a coloring agent in the total amount (as oxide) of 0.1 to 6.0% by weight, in a non-oxidizing atmosphere containing nitrogen gas at a temperature of 1400 to 1900 °C.

As a simple method to incorporate the above-mentioned metal elements, the metal elements, which may be oxides or other compounds thereof, are added in the form of powder to the above-mentioned mixture of Al₂O₃ powder and carbon powder, but they may be introduced as gas into a reaction apparatus. Also, Al₂O₃ and/or carbon containing these metals and/or their compounds in a predetermined amount can be used.

The present invention further provides a colored sintered body of aluminum nitride, comprising (i) aluminum nitride as a main component and (ii) at least one metal element selected from the group consisting of Ti, Zr, Hf, V, Ta, Cr, Mo, W, Mn, Ni, Nd and Ho and/or one or more compounds thereof incorporated and dispersed in each crystal grain as a coloring agent in the total amount of 0.01 to 5.0% by weight as metal based on the weight of AlN and having a thermal conductivity of at least 130 W/m.K and a flexural strength of at least 30 kg/mm².

The sintered body further contains at least one selected from Groups IIa and IIIa elements of the Periodic Table and/or one or more compounds thereof in the total amount 0.01 to 5.0% by weight (in terms of metal) based on the weight of AlN.

In order to prepare the sintered bodies of aluminum nitride, carbon or a carbon-containing compound capable of providing carbon after heating, in amounts of 0:01 to 1.0% by weight (as carbon) based on the weight of AlN is, added to the above specified aluminum nitride powder containing; besides aluminum nitride as a main component, at least one metal element selected from the group consisting of Ti, Zr, Hf, V, Ta, Cr, Mo, W, Mn, Ni, Nd and Ho and/or one or more compounds thereof incorporated and dispersed in each crystal grain as a coloring agent in the total amount of 0.1 to 3.0% by weight as metal based on the weight of AlN, molded and then fired in a non-oxidizing atmosphere containing nitrogen gas. Carbon or a carbon-containing compound capable of providing carbon after heating is needed to obtain the above colored sintered body having a high thermal conductivity of at least 130 W/m.K and a flexural strength of 30 kg/mm² or more, because it reduce Al₂O₃ existing on the surface of AlN. However, the residual carbon in the sintered aluminum nitride body must be below trace levels so as not to impair the properties of the ultimate aluminum nitride sintered product.

In this production process of the present invention, one or more elements selected from Groups IIa and IIIa elements of the Periodic Table and/or one or more compounds thereof in the total amount of 0.01 to 5.0% by weight in terms of metal on based on AlN may further be added as a sintering aid. As applicable compounds, oxides, nitrides, fluorides, carbides, etc., of the elements of Group IIa and IIIa are exemplified and, specifically, CaO, Y₂O₃, CaCO₃, CeO₂, CaC₂ and so on are mentioned.

This invention still further provides a circuit board using the above-mentioned colored sintered body of aluminum nitride as a substrate wherein printed circuits are formed onto the colored sintered body using a conductive paste.

Still further, the present invention provides a highly heat-conducting ceramic package comprising a substrate made of the highly thermal conductive, colored sintered body of aluminum nitride, a semiconductor device thereon and a lead-frame surrounding the substrate and the device.

### DETAILED DESCRIPTION OF THE PREFERRED EMBODIMENTS

For a better understanding, the present invention will be described in more, detail hereinafter.

In the aluminum nitride powder of the present invention, one or more components selected from the group consisting of Ti, Zr, Hf, V, Ta, Cr, Mo, W, Mn, Ni, Nd, Ho and compounds thereof are incorporated in each crystal grain as a coloring agent in the total amount of 0.1 to 3.0% by weight (calculated as metals) based on the weight of nitride aluminum. By using such an aluminum nitride powder as a raw material powder, the foregoing colored sintered body having a high thermal conductivity and a high flexural strength can be obtained by a usual sintering process. In the production of the aluminum nitride sintered body of the present invention, since the above aluminum nitride powder including one or more members of the specified metal elements and/or compounds thereof as the coloring agent is sintered, the amount of the coloring agent is reduced and a high thermal conductivity can be obtained together with a high flexural strength and a stable and dense color as compared with the case where the above metals and/or their compounds are added to powder of highly pure aluminum nitride.

In the preparation of the sintered bodies, aluminum nitride powder of high purity must be used. Especially, when it is desired to obtain a highly thermal conductive sintered body of aluminum nitride having a brown color or a green color, very pure aluminum nitride powder must be employed. When the aluminum nitride powder contains up to 2.5% by weight oxygen, up to 0.5% by weight carbon, up to 0.10% by weight (as metal) of impurities other than transition metals or compound thereof, and 0.1 to 3.0% by weight in the total amount (calculated in terms of metal) of the coloring metal elements and/or compound thereof, satisfactory thermal conductivity and flexural strength can be achieved together with a desired coloration.

The specific surface area of the aluminum nitride is preferably 2.0 m²/g or more (measured by BET method). When the specific surface are is less than 2.0 m²/g, the sintered bodies of high density can not be obtained.

In the present invention, as the coloring agent used to obtain the colored sintered bodies of aluminum nitride having a high thermal conductivity and a high flexural strength, there may be mentioned, for example, the following transition elements and their compounds.

As the additive for black coloration, there may be mentioned TiO₂, ZrO₂, HfO₂, V₂O₃, Ta₂O₃, Cr, Mo, WO₃; MnO, NiO, etc. Further, there may be added Nd₂O₃, etc., for brown coloration and Ho₃O₃, etc., for green coloration. However, the coloring agents which may be employed in the present invention are not limited to the oxide additives as mentioned above. Any compound can be used as long as it acts as the coloring agent by thermal decomposition. Examples of such compounds include carbonates, hydroxides, organic compound of the transition metal elements as mentioned above. Especially, Ti, Mo and W are preferably used and these coloring agents provide good sintered bodies.

When the total content of the metal elements and/or their compounds as the coloring agent in the AlN material powder is less than 0.1% by weight (calculated as metal), the resulting sintered bodies are not sufficiently colored and do, not provide satisfactory utility in applications where light transmittance must be prevented. When the coloring metal elements and/or their compounds exceed 3.0% by weight, the thermal conductivity of the resultant sintered products is reduced below 130 W/m.K, because the metal elements or their compounds dissolve into AlN to form a solid solution or they precipitate along the grain boundaries. Consequently, such low thermal conductive sintered bodies can not be used as IC substrates or the like. In order to achieve satisfactory coloring together with high levels of thermal conductivity and flexural strength, the content of oxygen is preferably in the range of 0.5 to 2.5% by weight. It preferable that the total content of elements (e.g. Si), which dissolve into AlN in the state of a solid solution, other than the above-mentioned coloring metal elements or their compounds is not more than 0.1% by weight as metal. Further, in order to obtain sintered bodies of high density, the specific surface area of the above AlN powder is preferably from 2.0 to 5.0 m²/g.

In preparing the AlN powder containing the above- mentioned coloring metal elements and/or their compounds, the weight ratio of Al₂O₃ powder to carbon powder is within the range of 1 : 0.2 to 1 : 2. When the range is less than 1 : 0.2, Al₂O₃ remains or agglomeration of the resultant AlN occurs because carbon is insufficient. On the other hand, when the ratio is beyond 1 : 2, carbon becomes excessive.

In the present invention, when one or more elements of Groups IIa and IIIa elements are further added in the above-specified amounts, better sinterability can be obtained with a high thermal conductivity, a high flexural strength and a coloring effect. When addition amounts of these elements is below 0.01% by weight or beyond 5.0% by weight, the effects contemplated by the present invention can not be obtained.

In the present invention, coloring agents capable of providing the same color may be in combination of two or more thereof and coloring agents of different colors may be also used in combination thereof.

The colored sintered aluminum nitride thus obtained according to the present invention have all a high thermal conductivity of at least 130 W/m.K and a high flexural strength of at least 30 kg/mm² and are useful as aluminum nitride substrates for circuit boards in which a thick film paste (e.g. Ag paste, Au paste, etc., or a high melting-point metal paste, for example of W, Mo, etc.) is printed onto the surface of the dense sintered body and then fired.

Further, the substrate thus obtained may be combined with a semiconductor device and a lead-frame to assemble an IC package.

The invention will be more clearly understood with reference to the following Examples.

### Example 1:

α-Al₂O₃ powder having an average particle size of 0.5 »m and acetylene black powder having an average particle size of 0.1 »m were mixed at a weight ratio of 1 : 0.5 and, to the resultant powdered mixture, metal oxides listed in Table 1 below were added as coloring agents in the respective proportions shown in the same table. All proportions are indicted based on the weight of AlN in the resulting AlN Powder. Each mixture was fired at 1550 °C for 3 hours in a nitrogen stream. The powder thus obtained was heated to a temperature of 700 °C to remove an excess carbon and was subjected to an elemental analysis. As the analytical results, the contents of the coloring elements are shown based on the weight of aluminum nitride in the resulting powder in the table below. In all AlN powder products, transition metals other than the coloring elements were not more than 10 ppm and the contents of oxygen was in the range of 1 to 1.5% by weight. Carbon was not detected. All powder products had a specific surface area of 3.5 m²/g (measured by BET method.)

1.0% by weight of phenol resin as a carbon source and 0.8% by weight of Y₂O₃ powder as a sintering aid were added to each AlN powder obtained above and thoroughly mixed. The resulting mixture was compacted to a disc having diameter of 12 mm and a thickness of 5 mm, using a single-axle pressing machine and fired at 1950 °C for 3 hours in a stream of nitrogen gas.

The thermal conductivity of each AlN sintered body is shown in Table 1 below. The light transmittance which was measured for a 0.3 mm-thick substrate of each AlN sintered body at a wavelength of 0.4 »m and the color are also shown below the table.

### Example 2:

α-Al₂O₃ powder having an average particle size of 0.5 »m and acetylene black powder having an average particle size of 0.1 »m were mixed at a weight ratio of 1 : 0.5 and, to the resultant powdered mixture, TiO₂ having an average particle size of 0.3 »m was added as a coloring agent in an amount such that the content of TiO₂ is 0.1% by weight based on the weight of AlN of the resultant AlN powder. The resultant mixture was fired at various temperatures of 1450 to 1850 °C or 60 minutes in a nitrogen stream and was heated to a temperature of 700 °C to remove an excess carbon. The properties of each of the aluminum nitride powders thus obtained are shown in Table 2. The specific surface area of each aluminum nitride powder was measured by the BET method and shown in Table 2.

1.0% by weight of phenol resin and 1.0% by weight of Y₂O₃ powder as a sintering aid were added to each AlN powder obtained above and thoroughly mixed. The resulting mixture was formed into a ceramic sheet and fired at 1900 °C for 5 hours in a stream of nitrogen gas.

The thermal conductivity of each AlN sintered body is shown in Table 2 below. The light transmittances through visible rays were all not greater than 1% and the colors were all black.

**Table 2**

| Sample No. | Properties of raw material powder | | Properties of sintered body | Firing temp. (°C) | Flexural strength (kg/mm²) |
|---|---|---|---|---|---|
| | Oxygen (wt.%) | Specific surface area(g/m²) | Thermal conductivity (W/m.K) | | |
| 20 | 3.0 | 8.0 | 80 | 1450 | 35 |
| 21 | 2.0 | 4.5 | 130 | 1550 | 35 |
| 22 | 2.0 | 3.5 | 160 | 1600 | 40 |
| 23 | 1.5 | 3.0 | 180 | 1650 | 35 |
| 24 | 0.7 | 2.5 | 130 | 1750 | 35 |
| 25 | 0.4 | 1.0 | 40 | 1850 | 35 |
| Sample Nos. 21 - 24: the present invention Sample Nos. 20 and 25: Comparative Examples | | | | | |

As described above, the present invention provides sintered aluminum nitride bodies having high levels of thermal conductivity and flexural strength and the sintered bodies are not semi-transparent white, but are colored in black, brown, green, etc. Accordingly, the sintered bodies of the present invention are very useful as excellent heat-releasing substrate materials or parts in IC substrates, packages or the like; in application in which light-transmission is undesirable; in optical sensors which are used in automatic operation lines, etc.

## Claims

1. An aluminum nitride powder comprising (i) aluminum nitride as a main Component and (ii) at least one metal element selected from the group consisting of Ti, Zr, Hf, V, Ta, Cr, Mo, W, Mn, Ni, Nd and Ho and/or one or more compounds thereof incorporated and dispersed in each crystal grain as a coloring agent in the total amount of 0.1 to 3.0% by weight (as metal) based on the weight of AlN.

2. An aluminum nitride powder as claimed in Claim 1 in which said aluminum nitride powder contains oxygen in the range of 0.5 to 2.5% by weight based on the weight of AlN and has a specific surface area of 2.0 to 5.0 m²/g.

3. A process of producing an aluminum nitride powder which comprises the steps of:
mixing Al₂O₃ powder and carbon powder at a weight ratio of 1 : 0.2 to 1 : 2; and
firing the resulting mixture in the presence of at least one metal element selected from the group consisting of Ti, Zr, Hf, V, Ta, Cr, Mo, W, Mn, Ni, Nd and Ho and/or one or more compounds thereof to be incorporated and dispersed as a coloring agent in each crystal grain in the total amount (as oxide) of 0.1 to 6.0% by weight based on the weight of AlN, in a non-oxidizing atmosphere containing nitrogen gas at a temperature of 1400 to 1900 °C.

4. A colored sintered body of aluminum nitride comprising (i) aluminum nitride as a main component and (ii) at least one metal element selected from the group consisting of Ti, Zr, Hf, V, Ta, Cr, Mo, W, Mn, Ni, Nd and Ho and/or one or more compounds thereof incorporated and dispersed in each crystal grain as a coloring agent in the total amount of 0.01 to 5.0% by weight (as metal) based on the weight of AlN and having a thermal conductivity of at least 130 W/m.K and a flexural strength of at least 294 MPa (30 kg/mm²).

5. A sintered body of aluminum nitride as claimed in Claim 4, in which said sintered body further contains at least one element selected from Groups IIa and IIIa elements of the Periodic Table and/or one or more compounds thereof in the total amounts of 0.01 to 5.0% by weight (as metal) based, on the weight of AlN.

6. A process of producing a colored sintered body which comprises the steps of:
adding carbon or a carbon-containing compound capable of providing carbon after heating, in amounts of 0.01 to 1.0% by weight (as carbon) based on the weight of AlN to an aluminum nitride powder comprising (i) aluminum nitride as a main component and (ii) at least one metal element selected from the group Consisting of Ti, Zr, Hf, V, Ta, Cr, Mo, W, Mn, Ni, Nd and Ho and/or one or more compounds thereof incorporated and dispersed as a coloring agent in each crystal grain in the total amount of 0.1 to 3.0% by weight (as metal) based on the weight of AlN;
molding the resulting intimate powder mixture; and firing the molded mixture in a non-oxidizing atmosphere containing nitrogen gas.

7. A process as claimed in Claim 6, in which at least one element selected from Groups IIa and IIIa elements of the Periodic Table and/or one or more compounds thereof in the total amount of 0.01 to 5.0% by weight (as metal) based on the weight of AlN is further added to said aluminum nitride powder prior to said molding step.

8. A circuit board comprising a sintered body of an aluminum nitride and a printed circuit formed on said sintered body using a conductive paste, wherein said sintered body of aluminum nitride comprises (i) aluminum nitride as a main component and (ii) at least one metal element selected from the group consisting of Ti, Zr, Hf, V, Ta, Cr, Mo, W, Mn, Ni, Nd and Ho and/or one or more compounds thereof incorporated and dispersed in each crystal grain as a coloring agent in the total amount of 0.01 to 5.0% by weight (as metal) based on the weight of AlN and having a thermal conductivity of at least 130 W/m.K and a flexural strength of at least 294 MPa (30 kg/mm²).

9. A circuit board as claimed in Claim 8, in which said sintered body further contains at least one element selected from Groups IIa and IIIa elements of the Periodic Table and/or one or more compounds thereof in the total amount of 0.01 to 5.0% by weight (as metal) based on the weight of AlN.

10. A highly heat-conductive ceramic package comprising a substrate made of a colored sintered body of aluminum nitride, a semiconductor device thereon and a lead-frame surrounding said substrate, wherein said sintered body of aluminum nitride comprises (i) aluminum nitride as a main component and (ii) at least one metal element selected from the group consisting of Ti, Zr, Hf, V, Ta, Cr, Mo, W, Mn, Ni, Nd and Ho and/or one or more compounds thereof incorporated and dispersed in each crystal grain as a coloring agent in the total amount of 0.01 to 5.0% by weight (as metal) based on the weight of AlN and having a thermal conductivity of at least 130 W/m.K and a flexural strength of at least 294 MPa (30 kg/mm²).

11. A ceramic package as claimed in Claim 10, in which said sintered body further contains at least one element selected from Groups IIa and IIIa elements of the Periodic Table and/or one or more compounds thereof in the total amount of 0.01 to 5.0% by weight (as metal) based on the weight of AlN.

## Patentansprüche

1. Ein Aluminiumnitridpulver, umfassend (i) Aluminiumnitrid als Hauptbestandteil und (ii) mindestens ein Metallelement, das aus der aus Ti, Zr, Hf, V, Ta, Cr, Mo, W, Mn, Ni, Nd und Ho und/oder einer oder mehrerer Verbindungen davon bestehenden Gruppe ausgewählt und als ein Färbungsmittel mit einen Gesamtanteil von 0,1 bis 3,0 Gewichts-% (als Metall), bezogen auf das AlN-Gewicht, in jedem Kristallkorn enthalten und dispergiert ist.

2. Ein Aluminiumnitridpulver, wie in Anspruch 1 beansprucht, in dem das Aluminiumnitridpulver Sauerstoff im Bereich von 0,5 bis 2,5 Gewichts-%, bezogen auf das AlN-Gewicht, enthält und einen spezifischen Oberflächenbereich von 2,0 bis 5,0 m²/g besitzt.

3. Ein Verfahren zur Herstellung eines Aluminiumnitridpulvers, umfassend die Schritte:
Mischen von Al₂O₃-Pulver und Kohlenstoffpulver in einem Gewichtsverhältnis von 1 : 0,2 bis 1 : 2; und
Brennen der resultierenden Mischung bei einer Temperatur von 1400 bis 1900°C in einer nicht-oxidierenden und Stickstoff enthaltenden Atmosphäre in Gegenwart von mindestens einem Metallelement, das aus der aus Ti, Zr, Hf, V, Ta, Cr, Mo, W, Mn, Ni, Nd und Ho und/oder einer oder mehrerer Verbindungen davon bestehenden Gruppe ausgewählt ist, um als Färbungsmittel im Gesamtanteil von 0,1 bis 6,0 Gewichts-% (als Oxid), bezogen auf das AlN-Gewicht, in jedem Kristallkorn enthalten und dispergiert zu sein.

4. Ein gefärbter Aluminiumnitrid-Sinterkörper, umfassend (i) Aluminiumnitrid als Hauptbestandteil und (ii) mindestens ein Metallelement, das aus der aus Ti, Zr, Hf, V, Ta, Cr, Mo, W, Mn, Ni, Nd und Ho und/oder einer oder mehrerer Verbindungen davon bestehenden Gruppe ausgewählt und als ein Färbungsmittel mit einen Gesamtanteil von 0,01 bis 5,0 Gewichts-% (als Metall), bezogen auf das AlN-Gewicht, in jedem Kristallkorn enthalten und dispergiert ist, und der eine Wärmeleitfähigkeit von wenigstens 130 W/m.K und eine Biegefestigkeit von mindestens 294 MPa (30 kg/mm²) aufweist.

5. Ein Aluminiumnitrid-Sinterkörper, wie in Anspruch 4 beansprucht, in dem der Sinterkörper weiterhin wenigstens ein Element, ausgewählt aus IIa- und IIIa-Gruppenelementen des Periodensystems und/oder einer oder mehrerer Verbindungen davon, im Gesamtanteil von 0,01 bis 5,0 Gewichts-% (als Metall), bezogen auf das AlN-Gewicht, enthält.

6. Ein Verfahren zur Herstellung eines gefärbten Sinterkörpers, umfassend die Schritte:
Zugeben von Kohlenstoff oder einer kohlenstoffhaltigen Verbindung, die fähig ist, nach dem Erhitzen Kohlenstoff bereitzustellen, in Beträgen von 0,01 bis 1,0 Gewichts % (als Kohlenstoff), bezogen auf das AlN-Gewicht, zu einem Aluminiumnitridpulver, das (i) Aluminiumnitrid als Hauptbestandteil und (ii) mindestens ein Metallelement umfaßt, das aus der aus Ti, Zr, Hf, V, Ta, Cr, Mo, W, Mn, Ni, Nd und Ho und/oder einer oder mehrerer Verbindungen davon bestehenden Gruppe ausgewählt und als ein Färbungsmittel mit einen Gesamtanteil von 0,1 bis 3,0 Gewichts-% (als Metall), bezogen auf das AlN-Gewicht, in jedem Kristallkorn enthalten und dispergiert ist; Formen der resultierenden, innig vermischten Pulvermischung; und
Brennen der geformten Mischung in einer nicht-oxidierenden und Stickstoff enthaltenden Atmosphäre.

7. Ein Verfahren, wie in Anspruch 6 beansprucht, in dem mindestens ein Element, ausgewählt aus den IIa- und IIIa-Gruppenelementen des Periodensystems und/oder einer oder mehrerer Verbindungen davon, im Gesamtanteil von 0,01 bis 5,0 Gewichts-% (als Metall), bezogen auf das AlN-Gewicht, zusätzlich zu dem Alumimiumnitridpulver vor dem Formungsschritt zugegeben wird.

8. Eine Schaltungskarte, die einen Sinterkörper aus einem Aluminiumnitrid und eine gedruckte Schaltung enthält, die unter Benutzung einer Leitpaste auf dem Sinterkörper ausgebildet ist, wobei der Sinterkörper aus Aluminiumnitrid (i) Aluminiumnitrid als Hauptbestandteil und (ii) mindestens ein Metallelement umfaßt, das aus der aus Ti, Zr, Hf, V, Ta, Cr, Mo, W, Mn, Ni, Nd und Ho und/oder einer oder mehrerer Verbindungen davon bestehenden Gruppe ausgewählt und als ein Färbungsmittel mit einen Gesamtanteil von 0,01 bis 5,0 Gewichts-% (als Metall), bezogen auf das AlN-Gewicht, in jedem Kristallkorn enthalten und dispergiert ist, und eine Wärmeleitfähigkeit von wenigstens 130 W/m.K und eine Biegefestigkeit von mindestens 294 MPa (30 kg/mm²) aufweist.

9. Eine Schaltungskarte, wie in Anspruch 8 beansprucht, in der der Sinterkörper weiterhin wenigstens ein Element, ausgewählt aus IIa- und IIIa- Gruppenelementen des Periodensystems und/oder einer oder mehrerer Verbindungen davon, im Gesamtanteil von 0,01 bis 5,0 Gewichts-% (als Metall), bezogen auf das AlN-Gewicht, enthält.

10. Eine hochwärmeleitende Keramikpackung, umfassend ein aus einem gefärbten Aluminiumnitrid-Sinterkörper hergestelltes Substrat, eine Halbleitervorrichtung darauf und einen das Substrat umschließenden Anschlußrahmen, wobei der Aluminiumnitrid-Sinterkörper (i) Aluminiumnitrid als Hauptbestandteil und (ii) mindestens ein Metallelement umfaßt, das aus der aus Ti, Zr, Hf, V, Ta, Cr, Mo, W, Mn, Ni, Nd und Ho und/oder einer oder mehrerer Verbindungen davon bestehenden Gruppe ausgewählt und als ein Färbungsmittel mit einen Gesamtanteil von 0,01 bis 5,0 Gewichts-% (als Metall), bezogen auf das AlN-Gewicht, in jedem Kristallkorn enthalten und dispergiert ist; und eine Wärmeleitfähigkeit von wenigstens 130 W/m.K und eine Biegefestigkeit von mindestens 294 MPa (30 kg/mm²) aufweist.

11. Eine Keramikpackung, wie in Anspruch 10 beansprucht, in der der Sinterkörper weiterhin wenigstens ein Element, ausgewählt aus IIa- und IIIa- Gruppenelementen des Periodensystems und/oder einer oder mehrerer Verbindungen davon, im Gesamtanteil von 0,01 bis 5,0 Gewichts-% (als Metall), bezogen auf das AlN-Gewicht, enthält.

## Revendications

1. Une poudre de nitrure d'aluminium comprenant (i) du nitrure d'aluminium en tant que composant principal et (ii) au moins un élément métallique choisi à partir du groupe constitué par les Ti, Zr, Hf, V, Ta, Cr, Mo, W, Mn, Ni, Nd et Ho et/ou un ou plusieurs de leurs composés, incorporés et dispersés en tant qu'agents colorants, à l'intérieur de chaque grain cristallin, dans la quantité totale comprise dans l'intervalle allant de 0,1 à 3,0 % en poids (calculée en tant que métal) par rapport au poids d'AlN.

2. Une poudre de nitrure d'aluminium telle que revendiquée dans la revendication 1, dans laquelle ladite poudre d'aluminium contient de l'oxygène en quantités allant de 0,5 à 2,5 % en poids par rapport au poids d'AlN et présente une surface spécifique allant de 2,0 à 5,0 m²/g.

3. Un procédé pour la fabrication d'une poudre de nitrure d'aluminium qui comprend les étapes suivantes :
le mélange d'une poudre d'Al₂O₃ et d'une poudre de carbone suivant un rapport en poids de 1:0,2 à 1:2; et
la cuisson du mélange résultant en présence d'au moins un des éléments métalliques choisis à partir du groupe constitué par les Ti, Zr, Hf, V, Ta Cr, Mo, W, Mn, Ni, Nd et Ho et/ou un ou plusieurs de leurs composés, que l'on incorpore et que l'on disperse en tant qu'agents colorants, à l'intérieur de chaque grain cristallin, dans la quantité totale (calculée en tant qu'oxyde) de 0,1 à 6,0 % en poids par rapport au poids d'AlN, au sein d'une atmosphère non-oxydante contenant de l'azote gazeux à une température allant de 1400 à 1900 °C.

4. Un corps fritté coloré à base de nitrure d'aluminium comprenant (i) du nitrure d'aluminium comme composant principal et (ii) au moins l'un des éléments métalliques choisis à partir du groupe constitué par les Ti, Zr, Hf, V, Ta, Cr, Mo, W, Mn, Ni, Nd et Ho et/ou un ou plusieurs de leurs composés, incorporés et dispersés en tant qu'agents colorants, à l'intérieur de chaque grain cristallin, dans la quantité totale de 0,01 à 5,0 % en poids (calculée en tant que métal) par rapport au poids d'AlN et présentant une conductivité thermique d'au moins 130 W/m.K et une résistance en flexion d'au moins 294 MPa (30 kg/mm²).

5. Un corps fritté à base de nitrure d'aluminium tel que revendiqué dans la revendication 4, dans lequel ledit corps fritté contient en outre l'un des éléments choisis à partir des groupes IIa et IIIa de la table périodique des éléments et/ou un ou plusieurs de leurs composés dans les quantités totales allant de 0,01 à 5,0 % en poids (calculée en tant que métal) par rapport au poids d'AlN.

6. Un procédé pour produire un corps fritté coloré, qui comprend les étapes suivantes :
l'addition de carbone ou d'un composé contenant du carbone susceptible d' apporter du carbone après chauffage, en quantités allant de 0,01 à 1,0 % en poids (calculé en tant que carbone) par rapport au poids d'AlN, à une poudre de nitrure d'aluminium comprenant (i) du nitrure d'aluminium en tant que composant principal et (ii) au moins l'un des éléments métalliques choisis à partir du groupe constitué par les Ti, Zr, Hf, V, Ta, Cr, Mo, W, Mn, Ni, Nd et Ho et/ou un ou plusieurs de leurs composés, que l'on incorpore et que l'on disperse en tant qu'agents colorants, à l'intérieur de chaque grain cristallin, dans la quantité totale qui va de 0,1 à 3,0 % en poids (calculée en tant que métal) par rapport au poids d'AlN;
le moulage du mélange intime des poudres résultant; et la cuisson du mélange moulé sous une atmosphère non-oxydante contenant de l'azote gazeux à une température allant de 1400 °C à 1900 °C.

7. Un procédé tel que revendiqué dans la revendication 6, dans lequel l'un au moins des éléments choisis à partir des groupes IIa et IIIa de la table périodique des éléments et/ou un ou plusieurs de leurs composés au sein de la quantité totale de 0,01 à 5,0 % en poids (calculée en tant que métal) par rapport au poids d'AlN, est en outre mélangé à ladite poudre de nitrure d'aluminium avant de passer à ladite étape de moulage.

8. Une plaquette de circuit imprimé comprenant un corps fritté à base de nitrure d'aluminium et un circuit imprimé gravé sur ledit corps fritté grâce à l'utilisation d'une pâte conductrice, dans lequel ledit corps fritté à base de nitrure d'aluminium comprend (i) du nitrure d'aluminium et (ii) l'un au moins des éléments métalliques choisis à partir du groupe constitué par les Ti, Zr, Hf, V, Ta, Cr, Mo, W, Mn, Ni, Nd et Ho et/ou un ou plusieurs de leurs composés, que l'on incorpore et que l'on disperse en tant qu'agents colorants, à l'intérieur de chaque grain cristallin, au sein de la quantité totale qui va de 0,01 à 5,0 % en poids (calculée en tant que métal) par rapport au poids d'AlN et qui présente une conductivité thermique d'au moins 130 W/m.K et une résistance en flexion d'au moins 294 MPa (30 kg/mm²).

9. Une plaquette de circuit intégré telle que revendiquée dans la revendication 8, dans laquelle ledit corps fritté contient en outre l'un au moins des éléments choisis à partir des groupes IIa et IIIa de la table périodique des éléments et/ou un ou plusieurs de leurs composés au sein de la quantité totale qui va de 0,01 à 5,0 % en poids (calculée en tant que métal) par rapport au poids d'AlN.

10. Un boîtier céramique de conductivité thermique élevée comprenant un substrat constitué d'un corps fritté coloré à base de nitrure d' aluminium, un dispositif semi-conducteur placé par-dessus et un cadre de sortie entourant ledit substrat, dans lequel ledit corps fritté à base de nitrure d'aluminium comprend (i) du nitrure d'aluminium en tant que composant principal et (ii) l'un au moins des éléments métalliques choisis à partir du groupe constitué par les Ti, Zr, Hf, V, Ta, Cr, Mo, W, Mn, Ni, Nd et Ho et/ou un ou plusieurs de leurs composés, que l'on incorpore et que l'on disperse en tant qu'agents colorants, à l'intérieur de chaque grain cristallin, au sein de la quantité totale qui va de 0,01 à 5,0 % en poids (calculée en tant que métal) par rapport au poids d'AlN et présentant une conductivité thermique d'au moins 130 W/m.K et une résistance en flexion d'au moins 294 MPa (30 kg/mm²).

11. Un boîtier céramique tel que revendiqué dans la revendication 10, dans lequel ledit corps fritté contient en outre l'un au moins des éléments choisis à partir des groupes IIa et IIIa de la table périodique des éléments et/ou un ou plusieurs de leurs composés au sein de la quantité totale qui va de 0,01 à 5,0 % en poids (calculée en tant que métal) par rapport au poids d'AlN.
